# EUROPEAN PATENT APPLICATION

(11) **EP 4 538 887 A1**
(43) Date of publication of application: **16.04.2025**
(21) Application number: 24157216.3
(22) Date of filing: 12.02.2024
(51) Int. Cl.: G06F 9/54

(54) **METHOD AND SYSTEM FOR OPTIMIZING THE SIMULATION PERFORMANCE OF A WHOLE VEHICLE MODE**

(30) Priority: 13.10.2023 US 202318379696; 26.10.2023 CN 202311405199
(71) Applicant: Shanghai Tosun Technology Ltd., Shanghai 201804 (CN)
(72) Inventor: LIU, Chu, Shanghai (CN); XIE, Yueyin, Shanghai (CN); MO, Mang, Shanghai (CN)
(74) Representative: Patentanwälte Gierlich & Pischitzis Partnerschaft mbB

(57) **Abstract**

This invention belongs to the field of vehicle software development technology and specifically relates to a method and a system for optimizing the simulation performance of a whole vehicle model, comprising: creating a real-time kernel program for executing real-time simulation tasks of the whole vehicle model; implementing inter-process communication between the real-time kernel program and a host software via shared memory, thereby enabling the reading and writing of vehicle simulation signals through the host software and the automatic control of the real-time kernel program to execute simulation commands, and to record the simulation data fed back from the real-time kernel program.

The method in this invention introduces an independently running real-time kernel program as a daemon for the host software. This transfers all performance-related operations on the host software to the real-time kernel program, thereby reducing the optimization overhead of the host software and achieving the objective of optimizing simulation performance.

## Description

### CROSS-REFERENCE TO THE RELATED APPLICATION

This application is based upon and claims priority to the Chinese Patent Application No. 2023114051991 filed on October 26, 2023, and the United States Patent Application No. 18/379,696 filed on October 13, 2023, the entire contents of which are incorporated herein by reference.

### TECHNIC FIELD

The present disclosure relates to the field of vehicle software development technologies, and in particular to a Method and system for optimizing the simulation performance of a whole vehicle mode.

### BACKGROUND

In the scenarios with high requirements for real-timeness, such as real-time control, real-time simulation, hardware-in-loop simulation, and co-simulation, program performances are of great importance. At present, most of the similar softwares achieve performance improvement by software optimization, for example, the program performance is optimized by replacing single thread with multiple threads, by exchanging space for time by using lookup table, or by avoiding iterative computation by using cache or the like. But, it is still difficult to optimize program performance to a higher performance level because the program performance, in much time, cannot be further optimized due to design framework and language limitation. In this case, many softwares cannot reach a higher performance level even though optimized.

### SUMMARY

The present disclosure relates to a system for optimizing the simulation performance of a whole vehicle model, including a computer device, wherein the computer device is configured to execute a real-time kernel program and a host software; wherein,
the real-time kernel program is configured as a daemon process of the host software to execute a vehicle model real-time simulation task;
the host software is configured to perform inter-process communication with the real-time kernel program through memory sharing to read and write a vehicle simulation signal, automatically control the real-time kernel program to execute a simulation command through a code program, and record simulation data fed back from the real-time kernel program;
after the real-time kernel program is configured as the daemon process of the host software, a method of automatically controlling the real-time kernel program to execute the simulation command through the code program includes:
preparing by the host software, to store command data in a shared memory, and sending a simulation event to the daemon process through the code program, such that the code program enters a state for monitoring the simulation event;
after the daemon process receives the simulation event, obtaining the command data corresponding to the simulation event from the shared memory to execute the corresponding command and feeding the completion information of the command execution back to the host software, so as to return the simulation event;
after the code program receives the simulation event returned by the daemon process, obtaining a corresponding command execution result from the shared memory.

The summary of the present disclosure aims to provide brief descriptions for the subjects of the specification. Thus, it should be understood that the above features are only illustrative and shall not be interpreted as narrowing the scope or essence of the subject of the specification in any way.

Other features, aspects and advantages of the subjects of the present disclosure will become apparent by way of the specific embodiments, drawings and claims.

### BRIEF DESCRIPTION OF THE DRAWINGS

In order to more clearly describe the technical solutions in the specific embodiments of the present disclosure or in the prior arts, the drawings required for descriptions of the specific embodiments or the prior arts will be briefly introduced below. Apparently, the drawings hereunder are some embodiments of the present disclosure, and other drawings may be obtained by those skilled in the arts based on these drawings without making creative work.
FIG. 1 is a schematic diagram illustrating steps of a method for optimizing the simulation performance of a whole vehicle mode according to one or more embodiments of the present disclosure.
FIG. 2 is a principle block diagram illustrating a computer device in a system for optimizing the simulation performance of a whole vehicle model according to one or more embodiments of the present disclosure.
FIG. 3 is a principle block diagram illustrating an electronic device according to one or more embodiments of the present disclosure.

### DETAILED DESCRIPTION OF THE EMBODIMENTS

In order to make the objects, the technical solutions and the advantages of the embodiments of the present disclosure clearer, the technical solutions of the present disclosure will be clearly and fully described below in combination with drawings. Apparently, the embodiments described herein are some embodiments of the present disclosure rather than all embodiments. All other embodiments obtained by those skilled in the arts based on these embodiments of the present disclosure without making creative work shall fall within the scope of protection of the present disclosure.

When a vehicle part is to be functionally tested, it is firstly required to enable this part to run normally. Therefore, a vehicle on which the part can run normally should be prepared to provide a complete electric environment, a network communication environment and a vehicle running state feedback and the like. Meanwhile, it is required to perform real-time control on the part to trigger it to generate a corresponding function during the running process of the vehicle and the part. In this process, the behavior of the part depends on the feedback information of the vehicle itself and the feedback information of other relevant parts.

It is extremely unrealistic to prepare one vehicle for each part, with all other relevant parts as environment. Further, in a special working condition, for example, in an emergency braking condition and a vehicle stability test process, the test method itself may bring vehicle damages and casualties. Therefore, under normal circumstances, it is required to employ a virtual method for a functional test of a part, namely, replace a true vehicle, sensors and other parts etc. with a vehicle model software to perform simulation so as to reduce costs, increase verification efficiency and guarantee personal safety. But, the real-timeness of the simulation leads to higher requirements for the simulation performance of the system program.

In view of the above, at least one embodiment provides a method for optimizing the simulation performance of a whole vehicle model, which includes: creating a real-time kernel program for executing a vehicle model real-time simulation task; enabling the real-time kernel program to perform inter-process communication with a host software through memory sharing to read and write a vehicle simulation signal through the host software, automatically control the real-time kernel program to execute a simulation command through a code program, and record simulation data fed back from the real-time kernel program.

In the method for optimizing the simulation performance of a whole vehicle mode provided by some embodiments, an independently-running real-time kernel program is introduced as a daemon process of the host software to transfer all performance-related operations on the host software to the real-time kernel program, so as to reduce the optimization overhead of the host software and achieve the purpose of simulation performance optimization.

Various non-limiting implementations of the embodiments of the present disclosure will be detailed below in combination with drawings.

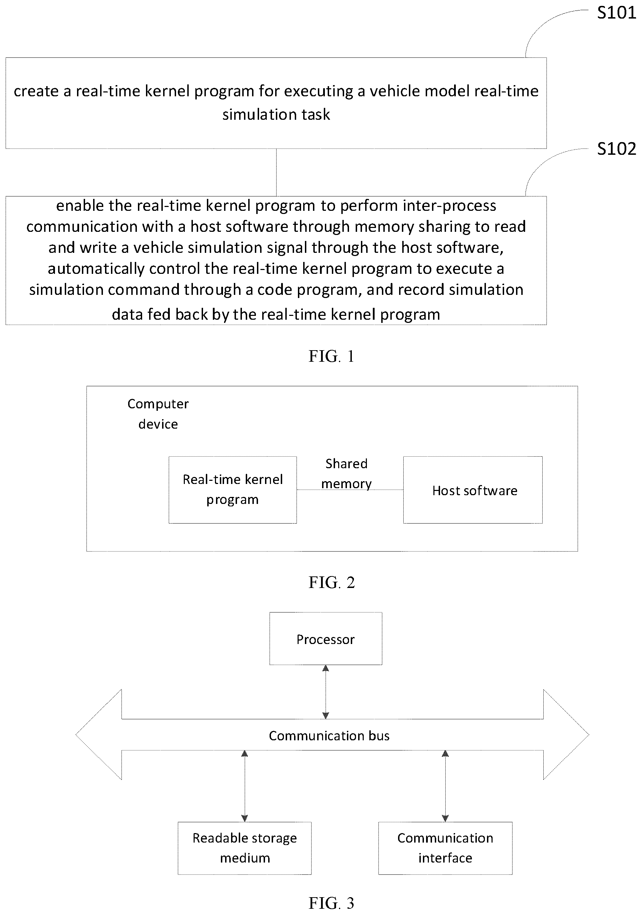

As shown in FIG. 1, one or more embodiments provide a method for optimizing the simulation performance of a whole vehicle model, which includes:
creating a real-time kernel program for executing a vehicle model real-time simulation task;
enabling the real-time kernel program to perform inter-process communication with a host software through memory sharing to read and write a vehicle simulation signal through the host software, automatically control the real-time kernel program to execute a simulation command through a code program, and record simulation data fed back from the real-time kernel program.

In some embodiments, the real-time kernel program refers to an internal core program specially designed to execute a real-time simulation task. The creation method includes but not limited to development by a development environment, for example, Visual Studio. The host software refers to a program which uses a real-time kernel program to directly serve the simulation and test requirements of a user. The code program refers to a user script program running in the host software, which can access the resources of the host software and run by relying on the host software itself. The host software can record simulation data in the present computer for data replay and analysis, and the simulation data recorded is used to evaluate a simulation result and facilitate searching for problems in a simulation process.

In some embodiments, the real-time kernel program is configured as a daemon process of the host software.

The daemon process can control its own process priority and simulation thread priority so as to optimize the simulation performance without being affected by the host software program and affecting the host software program. Furthermore, the daemon process may also interface with the host software program of any architecture, for example, support a 32-bit host software program and a 64-bit host software program.

As a preferred implementation of some embodiments, after the real-time kernel program is configured as the daemon process of the host software, a method of automatically controlling the real-time kernel program to execute the simulation command through the code program includes:
preparing by the host software, to store command data in a shared memory, and sending a simulation event to the daemon process through the code program, such that the code program enters a state for monitoring the simulation event;
after the daemon process receives the simulation event, obtaining the command data corresponding to the simulation event from the shared memory to execute the corresponding command and feeding the completion information of the command execution back to the host software, so as to return the simulation event;
after the code program receives the simulation event returned by the daemon process, obtaining a corresponding command execution result from the shared memory.

For example, a host software designed to run on a Windows platform calls a vehicle dynamics simulation engine CarSim to achieve the simulation of the vehicle model.

In the method of some embodiments, a real-time kernel program CSController is designed as a daemon process of the host software, and the real-time kernel program calls the API function "SetPriorityClass" of Windows upon startup to improve the priority of the daemon process. Meanwhile, the real-time kernel program calls the API function "SetThreadPriority" of Windows upon startup of a simulation thread (in this case, the simulation thread refers to a thread calling CarSim) to increase the priority of the thread. Therefore, it can be known that the daemon process can optimize its daemon process performance and simulation thread performance separately without being affected by the host software and affecting the host software, thereby reducing the optimization overhead of the host software and achieving the purpose of the simulation performance optimization.

The daemon process CSController is started to enable a shared memory for executing a simulation command and monitor an event name CmdTx, and the host software, during simulation startup, attempts to open the shared memory and will stop simulation and report an error if failing to do so.

After the host software successfully opens the shared memory, the simulation stage is started. The simulation command includes multiple types of operations. With a simulation startup command as an example, the data of the simulation startup command is set to 0x01, and the host software sets the first byte data of the shared memory to 0x01 and then sets the event CmdTx to send the simulation startup command to the daemon process. Next, the host software monitors the event name CmdRx to wait for completion of the command execution by the daemon process.

After obtaining the event name CmdTx, the daemon process reads the first byte data of the shared memory to determine what type of simulation command it is. When the daemon process reads the first byte data as 0x01, the daemon process starts simulation, where the simulation start may be successful or unsuccessful. It is supposed that the return value for success is 0 and the return value for failure is 1. The daemon process writes the return value for simulation start into the first byte of the shared memory and sets the event CmdRx to feed an execution result of the simulation command back to the host software. Next, the daemon process continues monitoring the event name CmdTx to wait for a next command from the host software.

After obtaining the event name CmdRx, the host software reads the first byte of the shared memory to determine an execution result of a previous command. When the byte data read is 0, it indicates the simulation start is successful, and when the byte data read is 1, it indicates that the simulation start is unsuccessful. The host software, based on contents to be executed next, sets the event name CmdTx again to control the daemon process to continue executing the simulation command.

In some embodiments, the daemon process may interface with the host software program of any architecture and can support both the 32-bit host software program and the 64-bit host software program. With the 32-bit host software program as an example, descriptions are made on a method of reading and writing the vehicle simulation signal after the real-time kernel program is configured as the daemon process of the host software.

In some embodiments, after the real-time kernel program is configured as the daemon process of the host software, a method of reading the vehicle simulation signal includes:
for reading a 32-bit integer simulation signal:
calling InterlockedIncrement function, introducing as parameters an address of the shared memory of the integer simulation signal and a value 0 to be added, and reading a function return value, so as to achieve the reading of the integer simulation signal.

Detailed descriptions are made below in combination with examples.

For example, when the value of the 32-bit integer gear signal Gear is read to the 32-bit integer variable "v", the codes for calling the InterlockedIncrement function are as follows:
v = InterlockedIncrement(&Gear, 0);
wherein, &Gear is an address of the shared memory of the integer gear signal Gear, 0 is a value to be added; the above codes are run to obtain a function return value and reading the function return value achieves reading for the 32-bit integer gear signal Gear.

In some embodiments, after the real-time kernel program is configured as the daemon process of the host software, a method of reading the vehicle simulation signal includes:
for reading a 32-bit floating -point simulation signal:
calling InterlockedIncrement function, introducing as parameters an address of the shared memory of the floating-point simulation signal and a value 0 to be added, and reading a function return value and then converting the function return value into a 32-bit floating-point value, so as to achieve the reading of the floating-point simulation signal.

A method of converting the function return value into the 32-bit floating-point value includes: taking 4 bytes back from a first address of the function return value as the 32-bit floating-point value.

Detailed descriptions are made below in combination with examples.

For example, when the value of the 32-bit floating-point signal Vx is read to the 32-bit floating-point variable "v", the codes for calling the InterlockedIncrement function are as follows:
*(int32*)(&v) = InterlockedIncrement(&Vx, 0);
wherein &Vx refers to an address of the shared memory of the floating-point signal Vx, 0 refers to a value to be added, &v refers to a first address of the function return value, *(int32*) refers to taking 4 bytes back from the first address of the function return value; the above codes are run to read an execution result so as to achieve reading for the 32-bit floating-point signal Vx.

In some embodiments, after the real-time kernel program is configured as the daemon process of the host software, a method of reading the vehicle simulation signal includes:
for reading a 64-bit integer simulation signal:
calling InterlockedIncrement64 function, introducing as parameters an address of the shared memory of the integer simulation signal and a value 0 to be added, and reading a function return value so as to achieve the reading of the integer simulation signal.

Detailed descriptions are made below in combination with examples.

For example, when the value of the 64-bit integer time signal TimeUs is read to the 64-bit integer variable "v", the codes for calling the InterlockedIncrement64 function are as follows:
v = InterlockedIncrement64(&TimeUs, 0);
wherein &TimeUs refers to an address of the shared memory of the integer time signal TimeUs, and 0 refers to a value to be added; the above codes are run to obtain a function return value, and reading the function return value achieves reading for the 64-bit integer time signal TimeUs.

In some embodiments, after the real-time kernel program is configured as the daemon process of the host software, a method of reading the vehicle simulation signal includes:
for f reading a 64-bit floating-point simulation signal:
calling InterlockedIncrement64 function, introducing as parameters an address of the shared memory of the floating-point simulation signal and a value 0 to be added, and reading a function return value and then converting the function return value into a 64-bit floating-point value, so as to achieve the reading for the floating-point simulation signal.

A method of converting the function return value into the 64-bit floating-point value includes:
taking 8 bytes back from a first address of the function return value as the 64-bit floating-point value.

Detailed descriptions are made below in combination with examples.

For example, when the value of the 64-bit floating-point signal EngForce is read to the 64-bit floating-point variable "v", the codes for calling the InterlockedIncrement64 function are as follows:
*(int64*)(&v) = InterlockedIncrement64(&EngForce, 0);
wherein &EngForce refers to an address of the shared memory of the floating-point signal EngForce, 0 refers to a value to be added, &v refers to a first address of the function return value, and *(int64*) refers to taking 8 bytes back from the first address of the function return value; the above codes are run to read an execution result so as to achieve reading for the 64-bit floating-point signal EngForce.

In some embodiments, after the real-time kernel program is configured as the daemon process of the host software, a method of writing the vehicle simulation signal includes:
for writing a 32-bit integer simulation signal:
calling InterlockedExchange function and introducing as parameters an address of the shared memory of the integer simulation signal and a value to be written.

Detailed descriptions are made below in combination with examples.

For example, when the value of the 32-bit integer signal x is written into the 32-bit integer gear signal Gear, the codes for calling the InterlockedExchange function are as follows:
InterlockedExchange(&Gear, x);
wherein &Gear refers to an address of the shared memory of the integer gear signal Gear, and x is a value to be added; the above codes are run to write the value of the 32-bit integer signal x to the 32-bit integer gear signal Gear.

In some embodiments, after the real-time kernel program is configured as the daemon process of the host software, a method of writing the vehicle simulation signal includes:
for writing a 32-bit floating-point simulation signal:
converting a to-be-written floating-point value into a integer value desired by a function parameter;
calling InterlockedExchange function and introducing as parameters an address of the shared memory of the floating-point simulation signal and the integer value obtained by conversion.

A method of converting the to-be-written floating-point value into the integer value desired by the function parameter includes:
taking 4 bytes back from a first address of the floating-point value as a 32-bit integer value.

Detailed descriptions are made below in combination with examples.

For example, when the value of the 32-bit floating-point signal x is written into the 32-bit floating-point signal Vx, the codes for calling the InterlockedExchange function are as follows:
InterlockedExchange(&Vx, *(int32*)(&x));
wherein &Vx refers to an address of the shared memory of the floating-point signal Vx, &x refers to a first address of the value of the floating-point signal x, and *(int32*) refers to taking 4 bytes back from the first address of the value of the floating-point signal x; the above codes are run to write the value of the 32-bit floating-point signal x into the 32-bit floating-point signal Vx.

In some embodiments, after the real-time kernel program is configured as the daemon process of the host software, a method of writing the vehicle simulation signal includes:
for writing a 64-bit integer simulation signal:
calling InterlockedExchange64 function and introducing as parameters an address of the shared memory of the integer simulation signal and a to-be-written value.

Detailed descriptions are made below in combination with examples.

For example, when the value of the 64-bit integer signal x is written into the 64-bit integer signal TimeUs, the codes for calling the InterlockedExchange64 function are as follows:
InterlockedExchange64(&TimeUs, x);
wherein &TimeUs refers to an address of the shared memory of the integer signal TimeUs, and x refers to a value to be added; the above codes are run to write the value of the 64-bit integer signal x into the 64-bit integer signal TimeUs.

In some embodiments, after the real-time kernel program is configured as the daemon process of the host software, a method of writing the vehicle simulation signal includes:
for writing a 64-bit floating-point simulation signal:
converting a to-be-written floating-point value into a integer value desired by the function parameter;
calling InterlockedExchange64 function and introducing as parameters an address of the shared memory of the floating-point simulation signal and the integer value obtained by conversion.

A method of converting the to-be-written floating-point value into the integer value desired by the function parameter includes:
taking 8 bytes back from a first address of the floating-point value as a 64-bit integer value.

Detailed descriptions are made below in combination with examples.

For example, when the value of the 64-bit floating-point signal x is written into the 64-bit floating-point signal EngForce, the codes for calling the InterlockedExchange64 are as follows:
InterlockedExchange64(&EngForce, *(int64*)(&x));
wherein &EngForce refers to an address of the shared memory of the floating-point signal EngForce, &x refers to a first address of the value of the floating-point signal x, and *(int64*) refers to taking 8 bytes back from the first address of the value of the floating-point signal x; the codes are run to write the value of the 64-bit floating-point signal x into the 64-bit floating-point signal EngForce.

As shown in FIG. 2, one or more embodiments further provide a system for optimizing the simulation performance of a whole vehicle model, which includes a computer device, where the computer device is configured to execute a real-time kernel program and a host software; where,
the real-time kernel program is configured as a daemon process of the host software to execute a vehicle model real-time simulation task;
the host software is configured to perform inter-process communication with the real-time kernel program through memory sharing to read and write a vehicle simulation signal, automatically control the real-time kernel program to execute a simulation command through a code program, and record simulation data fed back from the real-time kernel program.

Specifically, the specific working method of the real-time kernel program and the host software can be referred to the above descriptions of the method for optimizing the simulation performance of a whole vehicle mode and will not be repeated herein.

An electronic device in some embodiments will be described below from the angle of hardware processing.

In some embodiments, an electronic device includes a processor, a readable storage medium, a communication bus and a communication interface, wherein the processor, the readable storage medium and the communication interface communicate with each other via the communication bus;
the readable storage medium is configured to store at least one program that performs the method for optimizing the simulation performance of a whole vehicle model, and the processor is configured to execute the program that performs the method for optimizing the simulation performance of a whole vehicle model.

In some embodiments, the specific implementation of the electronic device is not limited.

As shown in FIG. 3, this electronic device includes a processor, a readable storage medium a communication bus and a communication interface, where the processor, the readable storage medium and the communication interface communicate with each other via the communication bus; the readable storage medium is configured to store at least one program that performs the above method for optimizing the simulation performance of a whole vehicle model, and the processor is configured to execute the program that performs the method for optimizing the simulation performance of a whole vehicle model.

In other embodiments, a computer device, and an industrial personal computer may be one of the electronic devices.

The structure shown in FIG. 3 does not constitute any limitation to the electronic device and thus may include more or less components than shown in the drawings or combine some components or have different components deployed.

In some embodiments, the communication interface may be RS232, RS485, USB interface or TYPE interface or the like, which may be connected with an external bus adapter. The communication interface may also include wired or wireless network interface. The network interface may optionally include wired interface and/or wireless interface (such as WI-FI interface, Bluetooth interface and the like), which is usually used to establish communication connection between the server and other computer devices.

The readable storage medium or the computer readable storage medium includes at least one type of memories. The memory includes flash memory, harddisk drive, multimedia card, card type memory (e.g. SD or DX memory or the like), magnetic memory, magnetic disk or compact disk or the like. In some embodiments, the memory may be an internal storage unit in the computer device, for example, a harddisk drive of the computer device. In some other embodiments, the memory may also be an external storage device of the computer device, for example, a plug type hard disk drive, a smart media card (SMC), a secure digital (SD) card, a flash card or the like on the computer device. Furthermore, the memory may include both the internal storage unit in the computer device and the external storage device. The memory may be used to not only store an application software installed on the computer device and various types of data, for example, the codes of the computer program and the like but also temporarily store data already output or to be output.

In some embodiments, the processor may be a central processing unit (CPU), a controller, a microcontroller, a microprocessor or another data processing chip, which is used to run the program codes in the memory or process the data, for example, execute the computer program or the like.

In some embodiments, the communication bus may also be an input/output bus, which may be a Peripheral Component Interconnect (PCI) bus, or an Enhanced Industry Standard Architecture (EISA) bus or the like. The bus may include an address bus, a data bus and a control bus and the like.

Optionally, the computer device may also include a user interface, which may include a display, and an input unit, for example, a keyboard. Optionally, the user interface may also include a standard wired interface and wireless interface. Optionally, in some embodiments, the display may be an LED display, a liquid crystal display, a touch liquid crystal display and an Organic Light-Emitting Diode (OLED) touch display and the like. The display may also be appropriately referred to as display screen or display unit for displaying information processed in the computer device as well as a visual user interface.

The processor executes the program to perform the steps of the embodiments of the method for optimizing the simulation performance of a whole vehicle mode shown in FIG. 1, for example, the steps S101 to S102 shown in FIG. 1. Alternatively, the processor executes at least one computer program to implement the functions of the modules or units in the device embodiments.

In some embodiments, the processor is specifically configured to perform the steps of:
creating a real-time kernel program for executing a vehicle model real-time simulation task;
enabling the real-time kernel program to perform inter-process communication with a host software through memory sharing to read and write a vehicle simulation signal through the host software, automatically control the real-time kernel program to execute a simulation command through a code program, and record simulation data fed back from the real-time kernel program.

Optionally, as one possible implementation, the processor is further configured to perform the steps of:
configuring the real-time kernel program as a daemon process of the host software.

Optionally, as one possible implementation, the processor is further configured to perform the following steps:
after the real-time kernel program is configured as the daemon process of the host software, a method of automatically controlling the real-time kernel program to execute the simulation command through the code program includes:
preparing by the host software, to store command data in a shared memory, and sending a simulation event to the daemon process through the code program, such that the code program enters a state for monitoring the simulation event;
after the daemon process receives the simulation event, obtaining the command data corresponding to the simulation event from the shared memory to execute the corresponding command and feeding the completion information of the command execution back to the host software, so as to return the simulation event;
after the code program receives the simulation event returned by the daemon process, obtaining a corresponding command execution result from the shared memory.

Optionally, as one possible implementation, the processor is further configured to perform the following steps:
after the real-time kernel program is configured as the daemon process of the host software, a method of reading the vehicle simulation signal includes:
for reading a 32-bit integer simulation signal:
calling InterlockedIncrement function, and introducing as parameters an address of the shared memory of the integer simulation signal and a value 0 to be added, and reading a function return value, so as to achieve the reading for the integer simulation signal.

Optionally, as one possible implementation, the processor is further configured to perform the following steps:
after the real-time kernel program is configured as the daemon process of the host software, a method of reading the vehicle simulation signal includes:
for reading a 32-bit floating -point simulation signal :
calling InterlockedIncrement function, introducing as parameters an address of the shared memory of the floating-point simulation signal and a value 0 to be added, and reading a function return value and then converting the function return value into a 32-bit floating-point value, so as to achieve the reading of the floating-point simulation signal.

Optionally, as one possible implementation, the processor is further configured to perform the following steps:
a method of converting the function return value into the 32-bit floating-point value includes:
taking 4 bytes back from a first address of the function return value as the 32-bit floating-point value.

Optionally, as one possible implementation, the processor is further configured to perform the following steps:
after the real-time kernel program is configured as the daemon process of the host software, a method of reading the vehicle simulation signal includes:
for reading a 64-bit integer simulation signal:
calling InterlockedIncrement64 function, introducing as parameters an address of the shared memory of the integer simulation signal and a value 0 to be added, and reading a function return value, so as to achieve the reading of the integer simulation signal.

Optionally, as one possible implementation, the processor is further configured to perform the following steps:
after the real-time kernel program is configured as the daemon process of the host software, a method of reading the vehicle simulation signal includes:
for reading a 64-bit floating-point simulation signal:
calling InterlockedIncrement64 function, introducing as parameters an address of the shared memory of the floating-point simulation signal and a value 0 to be added, reading a function return value and then converting the function return value into a 64-bit floating-point value, so as to achieve the reading of the floating-point simulation signal.

Optionally, as one possible implementation, the processor is further configured to perform the following steps:
a method of converting the function return value into the 64-bit floating-point value includes:
taking 8 bytes back from a first address of the function return value as the 64-bit floating-point value.

Optionally, as one possible implementation, the processor is further configured to perform the following steps:
after the real-time kernel program is configured as the daemon process of the host software, a method of writing the vehicle simulation signal includes:
for writing a 32-bit integer simulation signal:
calling InterlockedExchange function and introducing as parameters an address of the shared memory of the integer simulation signal and a value to be written.

Optionally, as one possible implementation, the processor is further configured to perform the following steps:
after the real-time kernel program is configured as the daemon process of the host software, a method of writing the vehicle simulation signal includes:
for writing a 32-bit floating-point simulation signal:
converting a to-be-written floating-point value into a integer value desired by a function parameter;
calling InterlockedExchange function and introducing as parameters an address of the shared memory of the floating-point simulation signal and the integer value obtained by conversion.

Optionally, as one possible implementation, the processor is further configured to perform the following steps:
a method of converting the to-be-written floating-point value into the integer value desired by the function parameter includes:
taking 4 bytes back from a first address of the floating-point value as a 32-bit integer value.

Optionally, as one possible implementation, the processor is further configured to perform the following steps:
after the real-time kernel program is configured as the daemon process of the host software, a method of writing the vehicle simulation signal includes:
for writing a 64-bit integer simulation signal:
calling InterlockedExchange64 function and introducing as parameters an address of the shared memory of the integer simulation signal and a to-be-written value.

Optionally, as one possible implementation, the processor is further configured to perform the following steps:
after the real-time kernel program is configured as the daemon process of the host software, a method of writing the vehicle simulation signal includes:
for writing a 64-bit floating-point simulation signal:
converting a to-be-written floating-point value into a integer value desired by the function parameter;
calling InterlockedExchange64 function and introducing as parameters an address of the shared memory of the floating-point simulation signal and the integer value obtained by conversion.

Optionally, as one possible implementation, the processor is further configured to perform the following steps:
a method of converting the to-be-written floating-point value into the integer value desired by the function parameter includes:
taking 8 bytes back from a first address of the floating-point value as a 64-bit integer value.

One or more embodiments further provide a computer readable storage medium storing at least one program that performs the above method for optimizing the simulation performance of a whole vehicle model, where the program is executed by a processor to perform the steps of the above method for optimizing the simulation performance of a whole vehicle model, where the steps are indicated in the specific descriptions of the method for optimizing the simulation performance of a whole vehicle mode in some embodiments and will not be repeated herein.

One or more embodiments further provide a computer program product, including a computer program or instruction, where the computer program or instruction is executed on a computer to cause the computer to perform any one of the method for optimizing the simulation performance of a whole vehicle models.

In some embodiments, a computer readable storage medium, storing computer readable instructions, wherein the computer readable instructions are executed by at least one processor to perform the method :
creating a real-time kernel program for executing a vehicle model real-time simulation task;
enabling the real-time kernel program to perform inter-process communication with a host software through memory sharing to read and write a vehicle simulation signal through the host software, automatically control the real-time kernel program to execute a simulation command through a code program, and record simulation data fed back from the real-time kernel program;
after the real-time kernel program is configured as a daemon process of the host software, a method of automatically controlling the real-time kernel program to execute the simulation command through the code program includes:
preparing by the host software, to store command data in a shared memory, and sending a simulation event to the daemon process through the code program, such that the code program enters a state for monitoring the simulation event;
after the daemon process receives the simulation event, obtaining the command data corresponding to the simulation event from the shared memory to execute the corresponding command and feeding the completion information of the command execution back to the host software, so as to return the simulation event;
after the code program receives the simulation event returned by the daemon process, obtaining a corresponding command execution result from the shared memory.

In some embodiments, a computer program product, including a computer readable storage medium on which computer readable program codes are stored, wherein the computer readable program codes include instructions, which cause at least one processor (one or more computer devices) to perform the following operations:
creating a real-time kernel program for executing a vehicle model real-time simulation task;
enabling the real-time kernel program to perform inter-process communication with a host software through memory sharing to read and write a vehicle simulation signal through the host software, automatically control the real-time kernel program to execute a simulation command through a code program, and record simulation data fed back from the real-time kernel program;
after the real-time kernel program is configured as a daemon process of the host software, a method of automatically controlling the real-time kernel program to execute the simulation command through the code program includes:
preparing by the host software, to store command data in a shared memory, and sending a simulation event to the daemon process through the code program, such that the code program enters a state for monitoring the simulation event;
after the daemon process receives the simulation event, obtaining the command data corresponding to the simulation event from the shared memory to execute the corresponding command and feeding the completion information of the command execution back to the host software, so as to return the simulation event;
after the code program receives the simulation event returned by the daemon process, obtaining a corresponding command execution result from the shared memory.

In the several embodiments provided by the present disclosure, it should be understood that the disclosed device and method can be implemented another way. The above device embodiments are merely illustrative, for example, the flowcharts or block diagrams in the drawings show possible system architectures, functions and operations of the device, method, and computer program product in the several embodiments provided by the present disclosure. Thus, each block in the flowcharts or block diagrams may represent one module, one program fragment or one part of codes. The module, the program fragment or the part of codes includes one or more executable instructions for implementing the specified logic functions. It should be noted that in some alternative embodiments, the functions indicated in the blocks may also be performed in a sequence different from that indicated in the drawings. For example, two continuous blocks can be actually performed basically in parallel, and sometimes may be performed in a reverse sequence, which is dependent on the functions involved. It is further noted that each block in the block diagrams and/or flowcharts and the combinations of the blocks in the block diagrams and/or flowcharts may be implemented by a dedicated hardware-based system for executing specified functions or actions, or by combination of dedicated hardware and computer instructions.

Furthermore, the functional modules in the embodiments of the present disclosure can be integrated into one independent part, or exist as separate modules or two or more of the modules are integrated into one independent part.

The functions, when implemented by software function modules and sold or used as independent products, can be stored in one computer readable storage medium. Based on such understanding, the essence of technical solutions of the present disclosure, or a part contributing to the prior arts or a part of the technical solutions can be embodied in the form of software product. The computer software product is stored in one storage medium which includes several instructions to enable one computer device (for example, a personal computer, a server, or a network device or the like) to perform all or part of the steps of the method of each of the embodiments of the present disclosure.

Enlightened by the ideal embodiments of the present disclosure, relevant workers can, based on the contents of the specification, make various changes and modifications within the scope of protection of the technical idea of the present disclosure. The technical scope of the present disclosure is not limited to the contents of the specification but to the technical scope claimed by the claims.

## Claims

1. A method for optimizing the simulation performance of a whole vehicle model, comprising:
creating a real-time kernel program for executing a whole vehicle model real-time simulation task;
enabling the real-time kernel program to perform inter-process communication with a host software through memory sharing to read and write a vehicle simulation signal through the host software, automatically control the real-time kernel program to execute a simulation command through a code program, and record simulation data fed back from the real-time kernel program;
after the real-time kernel program is configured as a daemon process of the host software, a method of automatically controlling the real-time kernel program to execute the simulation command through the code program comprises:
preparingby the host software, to store command data in a shared memory, and sending a simulation event to the daemon process through the code program, such that the code program enters a state for monitoring the simulation event;
after the daemon process receives the simulation event, obtaining the command data corresponding to the simulation event from the shared memory to execute the corresponding command and feeding completion information of a command execution back to the host software, so as to return the simulation event;
after the code program receives the simulation event returned by the daemon process, obtaining a corresponding command execution result from the shared memory.

2. The method for optimizing the simulation performance of a whole vehicle modeof claim 1, wherein,
after the real-time kernel program is configured as the daemon process of the host software, a method of reading the vehicle simulation signal comprises:
for reading a 32-bit integer simulation signal:
calling InterlockedIncrement function, introducing as parameters an address of the shared memory of the integer simulation signal and a value of 0 to be added, and reading a function return value, so as to achieve the reading of the integer simulation signal.

3. The method for optimizing the simulation performance of a whole vehicle modeof claim 1, wherein,
after the real-time kernel program is configured as the daemon process of the host software, a method of reading the vehicle simulation signal comprises:
for reading a 32-bit floating -point simulation signal:
calling InterlockedIncrement function, introducing as parameters an address of the shared memory of the floating-point simulation signal and a value of 0 to be added, and reading a function return value and then converting the function return value into a 32-bit floating-point value, so as to achieve the reading of the floating-point simulation signal.

4. The method for optimizing the simulation performance of a whole vehicle modeof claim 3, wherein,
a method of converting the function return value into the 32-bit floating-point value comprises:
taking 4 bytes back from a first address of the function return value as the 32-bit floating-point value.

5. The method for optimizing the simulation performance of a whole vehicle mode of claim 1, wherein,
after the real-time kernel program is configured as the daemon process of the host software, a method of reading the vehicle simulation signal comprises:
for reading a 64-bit integer simulation signal:
calling InterlockedIncrement64 function, introducing as parameters an address of the shared memory of the integer simulation signal and a value of 0 to be added, and reading a function return value, so as to achieve the reading of the integer simulation signal.

6. The method for optimizing the simulation performance of a whole vehicle mode of claim 1, wherein,
after the real-time kernel program is configured as the daemon process of the host software, a method of reading the vehicle simulation signal comprises:
for reading a 64-bit floating-point simulation signal:
calling InterlockedIncrement64 function, introducing as parameters an address of the shared memory of the floating-point simulation signal and a value of 0 to be added, and after reading a function return value and then converting the function return value into a 64-bit floating-point value, so as to achieve the reading of the floating-point simulation signal.

7. The method for optimizing the simulation performance of a whole vehicle mode of claim 6, wherein,
a method of converting the function return value into the 64-bit floating-point value comprises:
taking 8 bytes back from a first address of the function return value as the 64-bit floating-point value.

8. The method for optimizing the simulation performance of a whole vehicle mode of claim 1, wherein,
after the real-time kernel program is configured as the daemon process of the host software, a method of writing the vehicle simulation signal comprises:
for writing a 32-bit integer simulation signal:
calling InterlockedExchange function and introducing as parameters an address of the shared memory of the integer simulation signal and a value to be written.

9. The method for optimizing the simulation performance of a whole vehicle mode of claim 1, wherein,
after the real-time kernel program is configured as the daemon process of the host software, a method of writing the vehicle simulation signal comprises:
for writing a 32-bit floating-point simulation signal:
converting a to-be-written floating-point value into a integer value desired by a function parameter;
calling InterlockedExchange function and introducing as parameters an address of the shared memory of the floating-point simulation signal and the integer value obtained by conversion;
a method of converting the to-be-written floating-point value into the integer value desired by the function parameter comprises:
taking 4 bytes back from a first address of the floating-point value as a 32-bit integer value.

10. The method for optimizing the simulation performance of a whole vehicle mode of claim 1, wherein,
after the real-time kernel program is configured as the daemon process of the host software, a method of writing the vehicle simulation signal comprises:
for writing a 64-bit integer simulation signal:
calling InterlockedExchange64 function and introducing as parameters an address of the shared memory of the integer simulation signal and a to-be-written value.

11. The method for optimizing the simulation performance of a whole vehicle mode of claim 1, wherein,
after the real-time kernel program is configured as the daemon process of the host software, a method of writing the vehicle simulation signal comprises:
for writing a 64-bit floating-point simulation signal:
converting a to-be-written floating-point value into a integer value desired by the function parameter;
calling InterlockedExchange64 function and introducing as parameters an address of the shared memory of the floating-point simulation signal and the integer value obtained by conversion;and
a method of converting the to-be-written floating-point value into the integer value desired by the function parameter comprises:
taking 8 bytes back from a first address of the floating-point value as a 64-bit integer value.

12. A computer readable storage medium, storing computer readable instructions,
wherein the computer readable instructions are executed by at least one processor to perform the method for optimizing the simulation performance of a whole vehicle mode of any of claims 1-11.

13. An electronic device, comprising a processor, a readable storage medium, a communication bus and a communication interface, wherein the processor, the readable storage medium and the communication interface communicate with each other via the communication bus;
the readable storage medium is configured to store at least one program that performs the method for optimizing the simulation performance of a whole vehicle mode of any of claims 1-11, and the processor is configured to execute the program that performs the method for optimizing the simulation performance of a whole vehicle model.

14. A computer program product, comprising:
a computer program or instruction, where the computer program or instruction is executed on a computer to cause the computer to perform the method of any of claims 1-11.

15. A vehicle model simulation performance optimization system, comprising a computer device, wherein the computer device is configured to execute at least one program that performs the vehicle model simulation performance optimization method of any of claims 1-11.
